Europäisches Patentamt

European Patent Office

Office européen des brevets

(19)

(11) Numéro de publication: **0 263 543**
**A1**

(12) **DEMANDE DE BREVET EUROPEEN**

(21) Numéro de dépôt: **87201649.8**

(22) Date de dépôt: **31.08.87**

(51) Int. Cl.⁴: **C30B 15/00** , **C30B 27/02** , **C30B 29/40**

(30) Priorité: **05.09.86 FR 8612481**

(43) Date de publication de la demande:
**13.04.88 Bulletin 88/15**

(84) Etats contractants désignés:
**DE FR GB IT NL**

(71) Demandeur: **Laboratoires d'Electronique et de Physique Appliquée L.E.P.**
**3, Avenue Descartes**
**F-94450 Limeil-Brévannes(FR)**

(84) **FR**

(71) Demandeur: **N.V. Philips' Gloeilampenfabrieken**
**Groenewoudseweg 1**
**NL-5621 BA Eindhoven(NL)**

(84) **DE GB IT NL**

(72) Inventeur: **Farges, Jean-Pierre Société Civile S.P.I.D.**
**209, rue de l'Université**
**F-75007 Paris(FR)**

(74) Mandataire: **Landousy, Christian et al**
**Société Civile S.P.I.D. 209, Rue de l'Université**
**F-75007 Paris(FR)**

(54) **Procédé de réalisation d'un monocristal d'un composé semiconducteur du groupe III-V, par la méthode de tirage czochralski par encapsulation liquide.**

(57) Procédé de réalisation d'un monocristal du composé semiconducteur de phosphure d'indium (InP) mettant en oeuvre la méthode de tirage Czochralski par encapsulation liquide, parallèlement à l'axe cristallographique <111> défini avec la face phosphore (P) tournée vers le bain, ce procédé comprenant, pour diminuer le taux de dislocation dans le corps du lingot, la formation d'un rétrécissement du diamètre du lingot (ou gorge) en début de tirage sous le germe, caractérisé en ce qu'il comprend en outre, la formation à l'interface solide-liquide du tirage d'une face plane, de diamètre légèrement inférieur au diamètre du lingot obtenu selon une facette cristallographique perpendiculaire à l'axe de tirage, second moyen résultant en·la formation d'une discontinuité entre la zone centrale du cristal issue du tirage à partir de la partie plane de l'interface solide-liquide et la zone périphérique du cristal issue du tirage à partir de la zone non-plane externe à cette interface et résultant en l'existence, du fait des gradients thermiques à la température de tirage, d'une variation relative $\Delta a_0/a_0$ du paramètre de maille $a_0$ du phosphure d'indium (InP) non dopé de part et d'autre de la discontinuité, et l'introduction dans le bain de tirage d'ions dopants selon une concentration qui produit une variation relative $\Delta a/a$ du paramètre de maille $a$ du cristal dopé, variation $\Delta a/a$ sensiblement égale et de sens opposé à la variation relative $\Delta a_0/a_0$.

EP 0 263 543 A1

FIG.1a

Ia.

## PROCEDE DE REALISATION D'UN MONOCRISTAL D'UN COMPOSE SEMICONDUCTEUR DU GROUPE III-V, PAR LA METHODE DE TIRAGE CZOCHRALSKI PAR ENCAPSULATION LIQUIDE

L'invention concerne un procédé de réalisation d'un monocristal du composé semiconducteur de phosphure d'indium (InP) mettant en oeuvre la méthode de tirage Czochralski par encapsulation liquide, parallèlement à l'axe cristallographique <111> défini avec la face phosphore (P) tournée vers le bain, ce procédé comprenant, pour diminuer le taux de dislocation dans le corps du lingot :

-un premier moyen consistant en la formation d'un rétrécissement du diamètre du lingot (ou gorge) en début de tirage sous le germe.

L'invention trouve son application dans la réalisation de monocristaux semiconducteurs, de tous types de conductivité, notamment en phosphure d'indium (InP), présentant un taux de dislocations pratiquement nul et un grand diamètre supérieur ou égal à 30 mm.

Il est notoire que, à ce jour, la réalisation de gros monocristaux de phosphure d'indium (InP) est des plus difficiles, car les méthodes mises en oeuvre pour obtenir des gros monocristaux d'autres semi-conducteurs III-V, comme l'arséniure de gallium (GaAs) par exemple, ne donnent pas de bons résultats. Cependant au contraire, rien ne s'oppose à utiliser une méthode mise au point pour le phosphure d'indium, pour élaborer avec succès d'autres semiconducteurs du groupe III-V.

Un procédé de réalisation de monocristaux de phosphure d'indium, conforme au procédé décrit dans le préambule, est connu de la publication de Seiji SHINOYAMA et alii dans "Inst.Phys.Conf. Ser.No.63, chapter 1,pp-25-30". Cette publication a été présentée à "Int.Symp. GaAs and Related Compound, Japan, 1981", et reprend l'enseignement de la publication de Seiji SHINOYAMA et alii dans "Japanese Journal of Applied Physics, Vol.19, No.6, June 1980, pp. L331-L334". Le premier de ces documents décrit notamment un procédé de réalisation d'un monocristal de phosphure d'Indium (InP) par la méthode de tirage Czochralski par encapsulation liquide. Dans le but d'obtenir des lingots sans dislocations, ce procédé est fondé sur l'association de deux moyens. Le premier de ces moyens consiste en la formation d'un rétrécissement (necking) du diamètre du lingot en début de tirage, qui empêche les dislocations issues du germe de tirage de se propager dans l'intérieur du lingot. Le second moyen consiste en une charge considérable d'encapsulant liquide, en l'espèce $B_2O_3$ sous une épaisseur de 24 mm, soit 75 g de $B_2O_3$ pour 95 g d'InP, et permet d'obtenir un très faible gradient thermique vertical. Les cristaux sont tirés selon l'axe cristallographique <111> mais les conditions de tirage sont telles qu'aucune propriété spécifique due à cette direction de tirage n'est utilisée ni enseignée. D'autre part, les monocristaux sont formés soit non dopés intentionellement, soit légèrement dopés à l'aide des éléments Sn ou Fe, pour obtenir une conductivité de type n.A ce sujet, cette publication enseigne qu'un fort dopage à l'aide d'éléments tels que Zn, S ou Te produit une diminution du taux de dislocations mais que la variation du paramètre de maille de ces cristaux est alors importante et que ce procédé est limité à l'obtention de cristaux de conductivité très élevée.

Or, les circuits intégrés de la nouvelle génération requièrent des substrats en de nouveaux matériaux semi-conducteurs. Ainsi les circuits électro-optiques dont les longueurs d'onde de fonctionnement sont situées dans le domaine de 1,1 à 1,6$\mu$m, ou les transistors à effet de champ fonctionnant en hyperfréquences, ne peuvent être avantageusement réalisés à ce jour que sur le phosphure d'Indium (InP). Mais ces substrats doivent présenter une qualité très élevée. En premier lieu ils doivent être dépourvus de dislocations et de micro-défauts. En second lieu, ils doivent être de conductivité électrique choisie, soit de type p ou n, ou semi-isolant, et dans chaque type de conductivité, il doivent être d'un niveau contrôlé. En troisième lieu la grandeur de la maille cristalline du substrat doit être apte à permettre la réalisation des couches épitaxiales entrant dans l'élaboration des dispositifs ; le paramètre de maille cristalline de ce substrat doit donc présenter une dimension aussi voisine que possible de celui de ces couches épitaxiales, ce qui n'est pas possible lorsque sont introduits des éléments dopants dont le diamètre est très différent de celui des éléments du composé semiconducteur, ou lorsque ces éléments dopants sont introduits en trop grande quantité. En quatrième lieu, ces substrats doivent présenter une grande surface, et donc le lingot un grand diamètre pour permettre la réalisation des circuits intégrés électro-optiques qui sont d'une grande surface, ou la réalisation de nombreux circuits intégrés sur la même plaquette afin d'obtenir un bon rendement de fabrication.

Pour l'appl;ication envisagée, le procédé de réalisation de monocristaux décrit dans le document cité présente donc de nombreux désavantages :

-En premier lieu, il n'est pas possible d'obtenir des cristaux d'un diamètre supérieur à 15 mm sans voir apparaître de nombreuses dislocations ;

-En second lieu l'utilisation d'une charge d'encapsulant liquide ($B_2O_3$) aussi forte que celle qui est préconisée rend les conditions de tirage très difficiles.

-En troisième lieu, le contrôle du niveau de conductivité est mal dominé. Il 'est pas enseigné à réaliser une sélection des éléments dopants qui permette l'élaboration ultérieure de couches épitaxiales non perturbées, quel que soit le type de conductivité recherché.

-Il faut noter enfin que l'introduction de certains éléments dopants, outre le fait de modifier d'une façon inadéquate la dimension de la maille élémentaire, rend les lingots cassants à la découpe.

Ces inconvénients rendent l'application industrielle de ce procédé peu avantageuse.

La présente invention permet de s'affranchir de ces inconvénients et de réaliser des gros monocristaux notamment de phosphure d'indium (InP) avec un grand diamètre, supérieur à 40 mm, dans des conditions de tirage aisées à mettre en oeuvre industriellement, avec une conductivité voulue, avec un taux de dislocations pratiquement nul, dépourvus de micro-défauts, avec une dimension de maille cristalline apte à recevoir des couches épitaxiales non perturbées, et, entre autres avantages, non cassants à la découpe.

Selon l'invention ce but est atteint à l'aide d'un procédé de réalisation tel que décrit dans le préambule caractérisé en ce qu'il comprend en outre :

-un second moyen consistant en la formation à l'interface solide-liquide du tirage d'une face plane, de diamètre légèrement inférieur au diamètre du lingot obtenu selon une facette cristallographique perpendiculaire à l'axe de tirage, second moyen résultant en la formation d'une discontinuité entre la zone centrale du cristal issue du tirage à partir de la partie plane de l'interface solide-liquide et la zone périphérique du cristal issue du tirage à partir de la zone non-plane externe à cette interface et résultant en l'existence, du fait des gradients thermiques à la température de tirage, d'une variation relative $\Delta a_o/a_o$ du paramètre de maille $a_o$ du phosphure d'indium (InP) non dopé de part et d'autre de la discontinuité,

-un troisième moyen consistant en l'introduction dans le bain de tirage d'ions dopants selon une concentration qui produit une variation relative $\Delta a/a$ du paramètre de maille $\underline{a}$ du cristal dopé, variation $\Delta a/a$ sensiblement égale et de sens opposé à la variation relative $\Delta a_o/a_o$,

et en ce que les premier, deuxième et troisième moyens coopèrent pour que les dislocations qui se forment sous-jacentes au germe de tirage soient confinées, par la discontinuité, dans la zone périphérique du lingot, du fait que, lors du refroidissement la variation $\Delta a/a$ compense la varaition $\Delta a_o/a_o$.

Outre les avantages cités plus haut, le procédé selon l'invention présente encore un effet inattendu avantageux. Pour obtenir la compensation de la variation de la dimension de maille cristalline due aux gradients thermiques, une quantité d'agents dopants moitié des quantités préconisées par l'état de la technique est nécessaire, ce qui fait que le niveau de conductivité des cristaux obtenus n'est pas trop élevé et que le paramètre de maille cristalline du cristal dopé est peu différent de celui du cristal non dopé, permettant l'élaboration ultérieure de couches épitaxiales non perturbées.

L'invention sera mieux comprise à l'aide de la description suivante illustrée schématiquement par les figures annexées dont :

-la figure 1a qui représente en coupe selon l'axe I-I de tirage un monocristal ou lingot d'un composé semiconducteur III-V obtenu par le procédé selon l'invention ;

-la figure 1b qui est une coupe du même lingot selon un axe II-II ;

-la figure 1c qui est une coupe du même lingot selon l'axe I-I, au niveau de la gorge ;

-la figure 2 qui montre le lingot et son interface avec le bain de tirage, en coupe selon l'axe de tirage ;

-la figure 3 qui représente les variations du paramètre a de la maille cristalline d'InP en fonction de la concentration du dopant S.

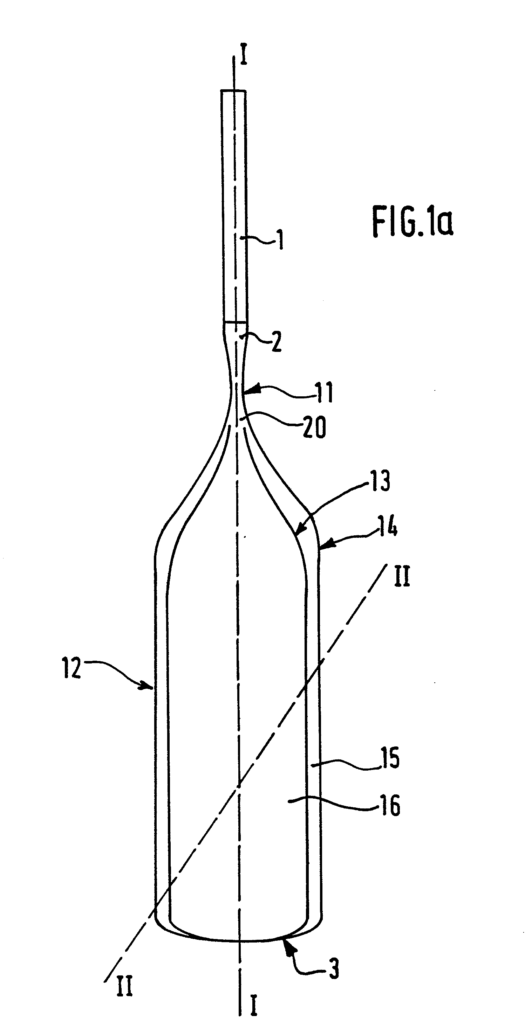

Tel que représenté sur la figure 1a, en coupe selon l'axe de tirage I-I, le lingot monocristallin obtenu par le procédé conforme à l'invention appliqué à la méthode Czochralski par encapsulation liquide, est un composé semiconducteur du groupe III-V. Il présente, à la suite de l'amorce de tirage 1, un corps de lingot qui comprend lui-même d'abord une partie 2 sous-jacente à l'amorce 1, puis une partie rétrécie ou gorge 11, puis une partie 12 de grand diamètre, et enfin une queue de lingot 3. La partir 12 de grand diamètre montre, parallèlement au bord externe 14 du lingot, une discontinuité 13. Comme il sera expliqué plus loin les propriétés du lingot sont différentes dans la zone 15 délimitée par le bord externe 14 et la discontinuité 13, et dans la zone interne 16 délimitée par la discontinuité 13. D'autre part, les propriétés de la zone 2 située entre l'amorce 1 et la gorge 11 sont également différentes des propriétés de la zone 16.

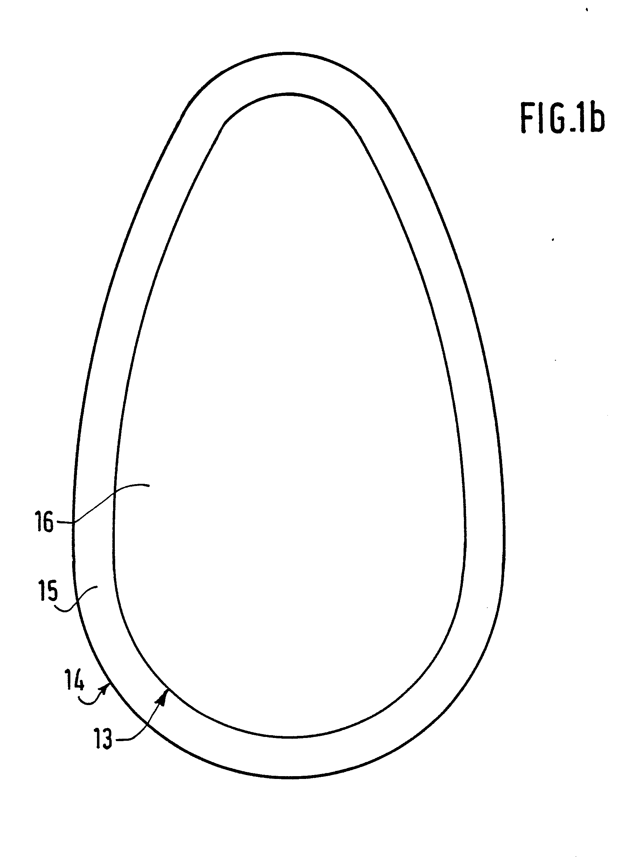

La figure 1b représente une coupe du lingot 1 selon l'axe II-II, choisi pour constituer une plaquette selon une orientation cristallographique intéressante pour l'élaboration ultérieure de dispositifs semi-conducteurs. Cette coupe est réalisée dans une région de grand diamètre du lingot. On y distingue la zone interne 16 délimitée par la discontinuité 13 qui est sensiblement parallèle au bord externe 14 du lingot, et la

3

zone dite externe 15 délimitée d'une part par le bord externe 14 et d'autre part par la discontinuité 13. La zone dite externe 15 contient une grande quantité de dislocations ou plans de glissement 8 alors que la zone interne 16 n'en contient pas. De même la zone 2 sous l'amorce contient un grand nombre de ces dislocations alors que la zone 20 sous la gorge n'en contient pas.

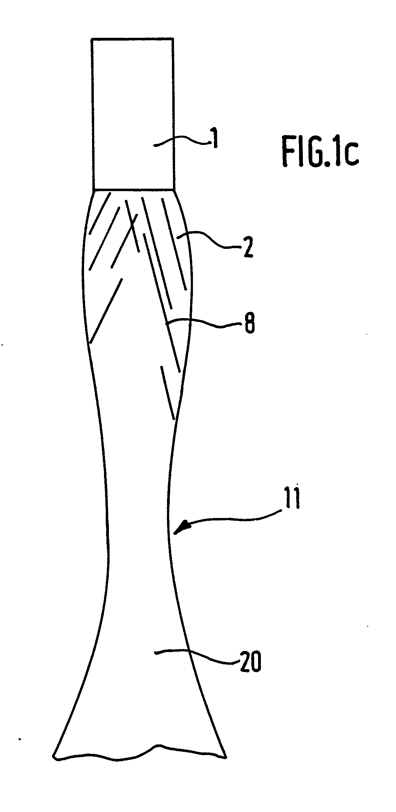

Comme il est enseigné par le document considéré comme état de la technique, la formation de la gorge 11 en début de tirage du lingot, par rétrécissement du diamètre de ce dernier, constitue un premier moyen qui fait en sorte que les dislocations 8 qui sont issues de l'amorce 1 sont arrêtées par cette gorge 1 du fait de leur orientation selon des plans cristallographiques inclinés par rapport à l'axe de tirage, et ne se propagent pas dans le corps du lingot tiré à la suite. Il apparaît alors, comme montré figure 1c, en coupe suivant I-I, après la gorge 11, une zone 20 qui est encore de faible diamètre mais qui est dépourvue de dislocations.

Mais selon ce document connu, on ne sait pas augmenter le diamètre de cette zone 20 jusqu'à des dimensions compatibles avec l'exploitation industrielle rentable du monocristal, même en employant des quantités extraordinaires d'encapsulant liquide. Dès que le lingot obtenu par le procédé connu du document cité atteint un diamètre de 15 mm, alors des dislocations apparaissent en grande quantité à la périphérie du lingot et se propagent vers l'intérieur de ce dernier jusqu'au centre.

Au contraire selon l'invention, le diamètre du lingot peut être augmenté au-delà de 40 mm ou 45 mm. Les dislocations apparaissent bien alors en grande quantité à la périphérie du lingot. Mais ces dislocations ne se propagent pas au-delà de la discontinuité 13. La zone interne 16, qui est le prolongement de la zone 20 sans dislocations, reste donc également dépourvue de dislocations. Le diamètre de cette zone 16 peut être supérieur à 30 mm.

L'obtention de la discontinuité 13 constitue le second moyen de l'invention, qui coopère avec le premier moyen constitué par la formation de la gorge, pour obtenir la zone interne 16, continuation de la zone 20, dépourvue de dislocations.

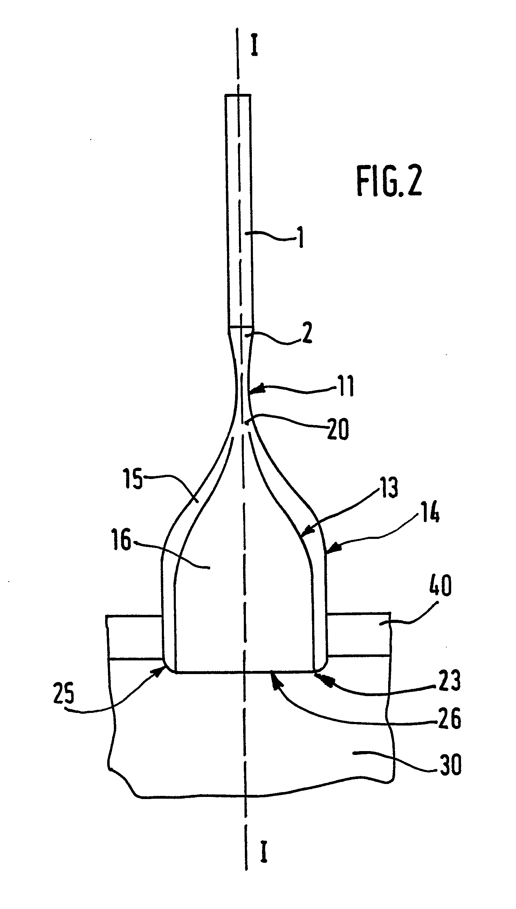

L'obtention de cette discontinuité 13 est fortement fonction des conditions d'élaboration du monocristal. Elle est tout particulièrement assujettie au choix d'un axe de tirage parallèle à un axe cristallographique tel qu'il existe une facette cristallographique perpendiculaire à cet axe, laquelle est alors capable de constituer dans certaines conditions de tirage une interface 26 solide-liquide plane sur une certaine surface. L'évolution du bord externe 23 de cette interface plane 26 forme, lors du tirage, la discontinuité 13. A l'extérieur de cette interface plane 26, et comme il est montré en coupe figure 2, l'interface solide-liquide est une concavité 25. Sur cette même figure 2, le bain de tirage porte la référence 30 et l'encapsulant liquide la référence 40.

La possibilité d'obtenir de telles facettes est signalée dans la publication de J.B. MULLIN dans "Compound Semiconductors, Vol.I, R.K. Willardson and H.L. Goering Editors, Reinhold New-York 1962".

Un troisième moyen est lié à l'utilisation de la différence qui apparaît entre le coefficient de ségrégation des impuretés le long de l'interface plane 26 et le coefficient de ségrégation des impuretés dans la zone 25 est utilisé en coopération avec le second moyen pour obtenir une compensation des variations des dimensions de la maille cristalline dues aux gradients thermiques et par là-même à la fois une diminution d'éventuelles dislocations résiduelles et une diminution de la perturbation des dimensions de la maille cristalline due auxdites impuretés, tout en obtenant le niveau recherché pour la conductivité du matériau.

Le comportement du coefficient de ségrégation des impuretés le long des facettes cristallographiques est enseigné d'une part par la publication de J.B. Mullin, et d'autre part par la publication de J.C. BRICE dans "The growth of crystals from the melt, Vol.5, E.P. Wohlfarth Editors, North Holland Publ. Co, 1965". En particulier, cette dernière publication enseigne que le coefficient de ségrégation des impuretés montre une discontinuité qui coïncide avec la discontinuité provoquée par le bord de l'interface plane de tirage solide-liquide, lorsque les conditions de tirage sont telles que cette interface existe.

Enfin la publication de M. DUSEAUX dans "J. of Crystals Growth, 61, 1983, p.576" enseigne que les dislocations sont principalement dues aux gradients thermiques qui apparaissent entre le bord externe du lingot et l'intérieur du lingot.

Connaissant le coefficient de dilatation du composé semiconducteur qui constitue le lingot, et la différence de température qui apparaît ainsi entre la zone interne 16 et la zone externe du lingot, il est alors possible de calculer la variation $\Delta a_0/a_0$ par rapport à la dimension de la maille cristalline $a_0$ du matériau non dopé intentionnellement, qui apparaît lors du tirage du fait des gradients thermiques entre les zones 15 et 16.

Selon l'invention, il est alors introduit dans le bain fondu, au moins un élément dopant, d'un type choisi pour engendrer une conductivité de type n, ou p, d'un diamètre tel et en quantité telle que la présence de cet élément dans le lingot refroidi engendre entre la zone interne 16 et la zone externe 15 une variation des dimensions de la maille cristalline $\Delta a/a$ du même ordre de grandeur et en sens opposé par rapport à la variation $\Delta a_o/a_o$ due aux gradients thermiques entre ces deux mêmes zones. L'introduction de l'élément dopant approprié et en quantité appropriée constitue le troisième moyen de l'invention.

Alors, au cours du refroidissement du lingot, la dimension de la maille cristalline reste constante dans la zone interne 16 du monocristal et les dislocations n'apparaissent pas.

L'agencement des moyens qui constituent l'invention procure alors un avantage inattendu décrit ci-après. Il était connu de l'état de la technique par la publication de Yasuo SEKI et alii dans "J. Appl. Phys. 49(2) February 1978" que l'introduction d'une quantité importante d'agents dopants provoquait, outre évidemment une conductivité d'un niveau élevé parfois indésirable, une diminution du taux de dislocations. Cette introduction d'une telle quantité d'agents dopants provoquait en même temps naturellement une variation du paramètre de maille cristalline importante impropre à l'élaboration ultérieure de couches épitaxiales de bonne qualité. Selon l'invention au contraire pour compenser les variations du paramètre de maille dues aux gradients thermiques, une quantité d'agent dopants en proportion moitié par rapport aux proportions enseignées par la publication de SEKI, est alors nécessaire. La variation du paramètre de maille a de la zone 16 du lingot refroidi sera donc faible par rapport à la valeur du paramètre de maille $a_o$ du cristal non dopé, et les couches épitaxiales ultérieures ne seront pas perturbées. De plus, le niveau de conductivité ne sera pas trop élevé.

Ainsi selon l'invention, le troisième moyen qui consiste en l'introduction dans le bain de tirage fondu, d'impuretés sélectionnées et en quantité calculée coopère avec les premier et second moyens pour confiner les dislocations dans la zone 15, pour éviter la formation de dislocations dans la zone interne 16, tout en contrôlant à la fois les dimensions des paramètres de maille cristalline et le niveau de conductivité électrique du matériau dans cette zone 16.

Le procédé selon l'invention est décrit ci-après plus particulièrement dans un exemple de mise en oeuvre.

## Exemple I

Le procédé selon l'invention est appliqué dans cet exemple à l'élaboration d'un monocristal de phosphure d'indium (InP), dopé au soufre (S).

Le procédé employé est la méethode de tirage Czochralski par encapsulation liquide de $B_2O_3$. Les conditions de tirage sont rassemblées dans le tableau I.

## TABLEAU I

- La charge initiale de matériau polycristallin :

      600 g pour un lingot de diamètre 35 mm

      1000 g pour un lingot de diamètre 45 mm

- L'agent dopant S provient de $In_2S_3$ et est introduit sous forme de poudre dans les proportions pondérales de $1,5.10^{-4}$ g à $2,5.10^{-4}$ g de $In_2S_3$ pour 1 g d'InP dans le bain fondu.

- La charge en encapsulant liquide est 150 g de $B_2O_3$.

- La pression en gaz $N_2$ est 40 bars.

- La vitesse de tirage est 1 à 2 $cm.h^{-1}$.

- La rotation du germe de tirage est 4 à 10 $t.mn^{-1}$, dans le sens des aiguilles d'une montre.

- La rotation du creuset est 30 à 60 $t \, mn^{-1}$, dans le sens contraire.

Le tirage est effectué dans un creuset en quartz, de diamètre 100 mm, comme il été dit par la méthode Czochralski sous encapsulation liquide, selon l'axe cristallographique <111> défini avec la face phosphore tournée vers le bain de tirage, condition qui permet la formation d'une face plane {111} de grand diamètre à l'interface solide liquide, avec les autres conditions de tirage définies dans le tableau I.

Le dopage à l'aide de l'élément soufre (S) permet d'obtenir des monocristaux de type de conductivité n.

Par la méthode de tirage conforme à l'invention, la concentration en ions dopants en tête du cristal est de l'ordre de $2.10^{18}$ et en queue de cristal de $3.10^{18}$, alors que selon l'état de la technique (SEKI) il était nécessaire d'atteindre une concentration double pour obtenir un effet bénéfique sur l'abaissement du taux de dislocations, ce qui provoquait une distorsion de la maille cristalline.

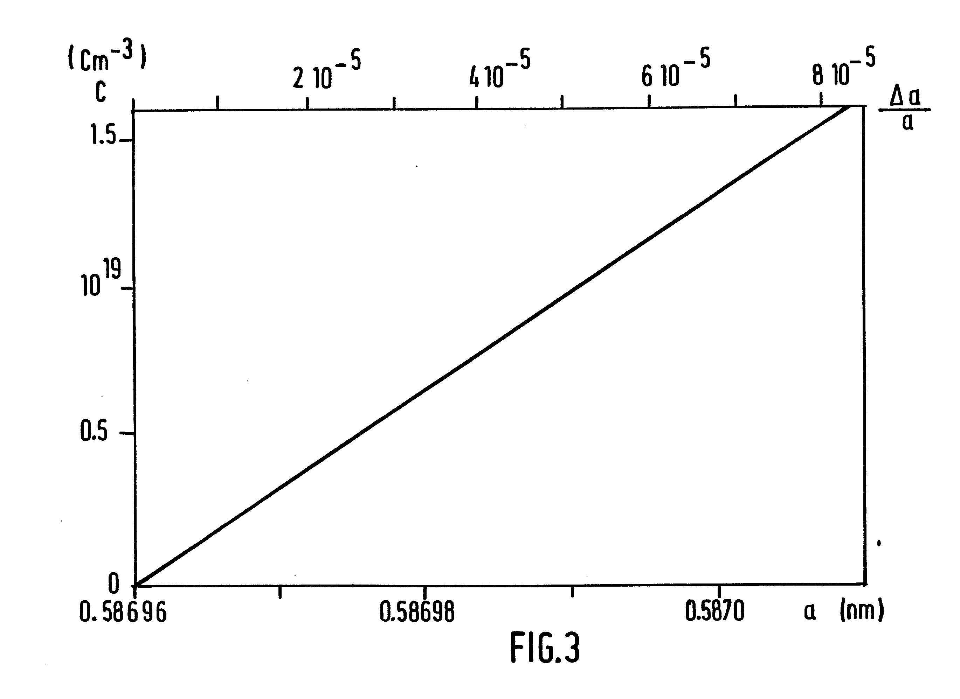

La figure 3 montre la droite représentative de la valeur en nm du paramètre de maille $\underline{a}$ en fonction de la concentration C en soufre (S) en $cm^{-3}$ et la variation relative $\Delta a/a$ du paramètre de maille du cristal dopé.

En partant des données connues (DUSEAUX) selon lesquelles lors du tirage la variation de température entre la zone interne et la zone externe du monocristal est de 10 à 15°K, alors avec un coefficient de dilatation de $8,76.10^{-6}$ au point de fusion Tf = 1335°K pour le phosphure d'indium (InP), la variation de la maille cristalline induite par les gradients thermiques est :

$1,5.10^{-5} \leq \Delta a_o/a_o \leq 2,2 . 10^{-5}$

Les valeurs du coefficient de dilatation d'InP sont connues par la publication de A.S. JORDAN dans "Journal of Crystal Growth 71 (1985) 559-565".

Or la figure 3 montre que, pour une concentration C en ions dopants de l'ordre de $2.10^{18}$ à $3.10^{18}$, la variation relative $\Delta a/a$ induite par le dopage entre zone interne et périphérique du cristal est

$10^{-5} \leq \Delta a/a < 2.10^{-5}$

Ce qui compense bien lors du refroidissement la variation $\Delta a_o/a_o$ due aux gradients thermiques entre ces zones, ces variations étant de sens opposé.

On constate en outre que le monocristal d'InP dopé au soufre (S) réalisé selon l'invention montre une très faible variation du paramètre de maille cristalline $\underline{a}$ du cristal dopé par rapport au paramètre de maille cristalline $\underline{a_o}$ du cristal non dopé, ce dernier étant :

$a_o = 0,586960$ nm à 25°C

Exemple II

Le procédé selon l'invention est appliqué dans cet exemple à l'élaboration d'un monocristal de phosphure d'indium (InP), dopé au Zn.

Le dopage à l'aide de l'élément Zn permet d'obtenir des monocristaux de type de conductivité p. Les conditions de tirage préconisées sont les mêmes que dans l'exemple I.

L'élément zinc (Zn) est introduit sous forme de poudre de zinc dans le bain de tirage fondu dans les proportions pondérales de $10^{-4}$ g de Zn pour 1g d'InP environ. Ces proportions résultent en un taux d'ions dopants dans le monocristal de l'ordre de $3.10^{18.cm-3}$, et en une variation relative

$\Delta a/a \simeq 10^{-5}$

apte à compenser la variation $\Delta a_0/a_0$.

Le paramètre de maille $\underline{a}$ du cristal dopé est ici encore, peut différent de celui du cristal non dopé.

Il faut souligner que selon le type de conductivité souhaité d'autres éléments dopants connus tels que Se ou Sb peuvent être utilisés.

D'autre part le procédé selon l'invention peut être appliqué à des composés du groupe III-V autres que InP, de même qu'à d'autres matériaux semiconducteurs aptes à être obtenus par la méthode Czochralski mais constitués d'autres éléments chimiques.

**Revendications**

1. Procédé de réalisation d'un monocristal du composé semiconducteur de phosphure d'indium (InP) mettant en oeuvre la méthode de tirage Czochralski par encapsulation liquide, parallèlement à l'axe cristallographique <111> défini avec la face phosphore (P) tournée vers le bain, ce procédé comprenant, pour diminuer le taux de dislocation dans le corps du lingot :
-un premier moyen consistant en la formation d'un rétrécissement du diamètre du lingot (ou gorge) en début de tirage sous le germe, caractérisé en ce qu'il comprend en outre :
-un second moyen consistant en la formation à l'interface solide-liquide du tirage d'une face plane, de diamètre légèrement inférieur au diamètre du lingot obtenu selon une facette cristallographique perpendiculaire à l'axe de tirage, second moyen résultant en la formation d'une discontinuité entre la zone centrale du cristal issue du tirage à partir de la partie plane de l'interface solide-liquide et la zone périphérique du cristal issue du tirage à partir de la zone non-plane externe à cette interface et résultant en l'existence, du fait des gradients thermiques à la température de tirage, d'une variation relative $\Delta a_0/a_0$ du paramètre de maille $a_0$ du phosphure d'indium (InP) non dopé de part et d'autre de la discontinuité,
-un troisième moyen consistant en l'introduction dans le bain de tirage d'ions dopants selon une concentration qui produit une variation relative $\Delta a/a$ du paramètre de maille $\underline{a}$ du cristal dopé, variation $\Delta a/a$ sensiblement égale et de sens opposé à la variation relative $\Delta a_0/a_0$,
et en ce que les premier, deuxième et troisième moyens coopèrent pour que les dislocations qui se forment sous-jacentes au germe de tirage soient confinées, par la discontinuité, dans la zone périphérique du lingot, du fait que, lors du refroidissement la variation $\Delta a/a$ compense la variation $\Delta a_0/a_0$.

2. Procédé de réalisation selon la revendication 1, caractérisé en ce que les ions dopants sont les éléments soufre(S) pour obtenir un monocristal du type de conductivité $\underline{n}$ et en ce que la compensation de la variation $\Delta a_0/a_0$ par la variation $\Delta a/a$ est obtenue par l'introduction de ces ions soufre, dans le bain fondu, sous forme de poudre de sulfure d'indium ($In_2S_3$) dans les proportions pondérales de $1,5.10^{-4}$ à $2,5.10^{-4}$ g de $In_2S_3$ pour 1 g de InP produisant une concentration en impuretés de $2.10^{18}.cm^{-3}$ à $3.10^{18}.cm^{-3}$ dans la partie centrale du cristal, et une variation $\Delta a/a$ de $10^{-5}$ à $2.10^{-5}$.

3. Procédé de réalisation selon la revendication 1, caractérisé en ce que les ions dopants sont les éléments zinc (Zn) pour obtenir un monocristal de type de conductivité p et en ce que la compensation de la variation $\Delta a_0/a_0$ par la variation $\Delta a/a$ est obtenue par l'introduction de ces ions zinc, dans le bain fondu, sous la forme de poudre de zinc (Zn) dans les proportions pondérales de environ $10^{-4}$ g de zinc (Zn) pour 1g de phosphure d'indium (InP) produisant une concentration en impuretés de l'ordre de $3.10^{18}.cm^{-3}$ dans la partie centrale du cristal, et une variation $\Delta a/a$ de l'ordre de $10^{-5}$.

FIG.1a

FIG.1b

16

15

14

13

FIG.1c

1

2

8

11

20

FIG.2

FIG.3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | JOURNAL OF CRYSTAL GROWTH, vol. 66, no. 2, avril 1984, pages 317-326, Elsevier Science Publishers B.V., (North-Holland Physics Publishing Division), Amsterdam, NL; P.J. ROKSNOER et al.: "The single crystal growth and characterization of indium phospide" * Pages 317,318 * | 1-3 | C 30 B  15/00<br>C 30 B  27/02<br>C 30 B  29/40 |
| A | JOURNAL OF CRYSTAL GROWTH, vol. 66, no. 2, avril 1984, pages 327-332, Elsevier Science Publishers B.V., (North-Holland Physics Publishing Division), Amsterdam, NL; D-F. FANG et al.: "Growth and properties of InP single crystals" * Page 329 * | 1-3 | |
| A | JOURNAL OF CRYSTAL GROWTH, vol. 52, 2e partie, 1981, pages 591-596, North-Holland Publishing Co., Amsterdam, NL; C. UEMURA et al.: "LEC growth and characterization of undoped InP crystals" * Pages 592-593 * | 1 | |

DOMAINES TECHNIQUES RECHERCHES (Int. Cl.4)

C 30 B

Le présent rapport a été établi pour toutes les revendications

| Lieu de la recherche | Date d'achèvement de la recherche | Examinateur |
|---|---|---|
| LA HAYE | 11-12-1987 | COOK S.D. |